(19) **Europäisches Patentamt**
**European Patent Office**
**Office européen des brevets**

(11) Publication number: **0 266 225**
**A1**

(12) # EUROPEAN PATENT APPLICATION

(21) Application number: **87309657.2**

(22) Date of filing: **30.10.87**

(51) Int. Cl.4: **C 08 J 7/04**
**C 23 C 14/02**

(30) Priority: **31.10.86 JP 258191/86**

(43) Date of publication of application:
**04.05.88 Bulletin 88/18**

(84) Designated Contracting States: **DE FR GB**

(71) Applicant: **HASHIMOTO FORMING INDUSTRY CO LTD**
**320 Aza-Fujii Kamiyabe-cho Totsuka-ku**
**Yokohama City Kanagawa Pref. (JP)**

(72) Inventor: **Ohtake, Shinichi Hashimoto Forming Indus. Co. Ltd.**
**320, Aza-Fujii Kamiyabe-Cho Totsuka-Ku**
**Yokohama City Kanagawa Pref. (JP)**

(74) Representative: **Senior, Alan Murray**
**J.A. KEMP & CO 14 South Square Gray's Inn**
**London WC1R 5EU (GB)**

(54) **Method of producing plastic-moulded articles with hard coated surface layers.**

(57) A method for producing plastic-molded articles with a hard coated surface layer is disclosed. The method includes formation of a silicone-based coated layer on the surface of base material, and formation of $SiO_2$ film on the coated layer. The article so produced has excellent hardness, scratch-proof and wear resistance properties, effectively prevents separation or crack-formation, and is suitable for various automobile components including window screens.

*FIG. 1*

EP 0 266 225 A1

## Description

### Method of Producing Plastic-molded Articles With Hard Coated Surface Layers

The present invention relates to a method of producing plastic-molded articles with hard-coated surface layer, adapted to be used as automobile components.

Currently, plastic-molded articles are widely used as automobile components, and there have been various proposals regarding replacement of components made of conventional materials, with plastic-molded articles. One such proposal is directed to an automobile window screen formed of a transparent plastic-molded plate with a hardened surface layer, used instead of conventional inorganic glass plate. Conventional method of producing plastic-molded articles with hardened surface layers includes formation of a silicone-based hard coated surface layer by means of so-called spray process, dipping process or flow-coating process, as disclosed in Japanese Patent Application Laid-open Publication Nos. 57-177,028 and 61-143,445, etc., as well as formation of $SiO_2$ film by means of ion-plating or the like physical vapor deposition (PVD) process, as disclosed in Japanese Patent Application Laid-open Publication No. 58-29,835.

Plastic-molded articles with silicon-based hard coated surface layers, obtained by the above-mentioned conventional process, exhibit excellent properties such as scratch-proof, wear resistance, chemical resistance and weatherproof. However, for particular automobile components which are repeatedly subjected to a severe friction force, such as window screens, sufficient scratch-proof and wear resistance properties required from practical viewpoint cannot be achieved by known plastic-molded articles even with hard coated surface layers.

Moreover, when the hard coated surface layer is a $SiO_2$ film formed directly on the base material surface, adhesion of the film to the base material surface is insufficient, often giving rise to undesirable separation of the film from the base material surface, or to formation of cracks in the film.

Accordingly, it is an object of the present invention to provide an improved method of producing plastic-molded articles with hard coated surface layers firmly adhered to the base material, thereby to prevent undesirable separation or crack formation, while at the same time providing excellent hardness, scratch-proof and wear resistance properties.

The method according to the present invention comprises the steps of forming a silicone-based coated layer on the surface of base material, and forming a $SiO_2$ film on said silicone-based coated layer.

The present invention will now be described in further detail hereinafter.

To carry out the method according to the present invention, the article may be essentially formed of various kinds of plastic material, including acrylic resin, polycarbonate resin, polyester resin and polystyrene resin. Furthermore, use of transparent plastic material makes it possible to produce automobile window screens, sun roofs, etc., requiring transparency. Among others, acrylic resin may be used advantageously since it is capable of establishing an excellent adhesion to the silicone-based coated layer. Other plastic materials with a relatively poor adhesion to the silicone-based coated layer may also be used when its adhesion to the silicone-based coated layer can be improved by a primer layer. The molded article may be of plate-shaped or hollow configuration, and may have the shape of final product.

The silicone-based coated surface layer may be composed of compounds with siloxane linkage, which are used for surface hardening of plastic material and to form hard coated surface layers. The silicone-based hard coated layer can thus be obtained, e.g. by applying to the surface of the base plastic material known silicone-based coating agent such as that disclosed in the above-mentioned Japanese Patent Application Laid-open Publication No. 57-177,028, which consists essentially of partial hydrolyzate obtained from a mixture of tetraalkoxysilicone and compound of the general formula $RnSi(OR')_{4-n}$, wherein n is an integer of from 1 to 3, R is a hydrocarbon group with carbon number of from 1 to 6, and R' is an alkyl group with carbon number of from 1 to 4, or which consists essentially of a mixture of respective partial hydrolyzates of said compound and tetraalkoxysilicone. Such a coating agent is available on market under the trademark "SUMIUNI" as the product of Sumitomo Kagaku Kogyo K.K., Japan. The silicone-based coating agent may also be a mixture consisting essentially of methylsilylsesquisiloxane and colloidal silica, which is also available on market under the trademark "TOSGUARD" as the product of Toshiba Silicone K.K., Japan.

When the above-mentioned silicone-based coated layer exhibits a good adhesion with the base plastic-molded article, e.g. when the article is composed of acrylic resin, the coated layer can be formed directly on the surface of the article. However, when the coated layer lacks in a good adhesion with the base plastic-molded article, e.g. when the article is composed of polycarbonate resin, the adhesion can be improved by forming an intermediate primer layer.

Such a primer layer may consists of a coating agent having a good adhesion to the base plastic-molded article and also to the silicone-based coating layer, such as acrylic-urethane or polyester-based agent, or other suitable coating agent.

The $SiO_2$ film on the silicone-based coated layer may be formed by known physical vapor deposition (PVD) process, such as ion-plating, vacuum evaporation, sputtering, and is preferably formed by hot-electron type ion plating. Such a process is disclosed in the above-mentioned Japanese Patent Application Laid-open Publication No. 58-29,835.

The $SiO_2$ film formed on the silicone-based coated layer on the surface of plastic-molded article has an excellent hardness due to its molecular structure which is similar to that of inorganic glass, and exhibits a good adhesion to the coated layer, which is believed as resulting from the fusion of the silicon of $SiO_2$ and the silicon of siloxane, that have been diffused on the interface between the $SiO_2$ film and the silicone-based coated layer. On the other hand, since the silicone-based coated layer consists of an organic silicone compound, the coated layer exhibits a good adhesion to the surface of base material, i.e. the plastic-molded article itself, or the primer layer formed thereon. Consequently, plastic-molded article with hard coated layers can be obtained, exhibiting good adhesion as a whole and having excellent scratch-proof and wear resistance properties.

The plastic-molded articles with hard coated layers, produced in accordance with the present invention, can be used as transparent or opaque automobile components, such as front, rear and side window screens, sun roofs, lens for head light, illumination or signal lamps, finishers and wheel covers, and can also be used for other purposes.

The present invention will now be described with reference to certain preferred examples as shown in the attached drawings.

Fig. 1 is a flow chart showing in cross-section the process steps of example 1; and

Fig. 2 is a flow chart showing in cross-section the process steps of example 2.

Example 1:

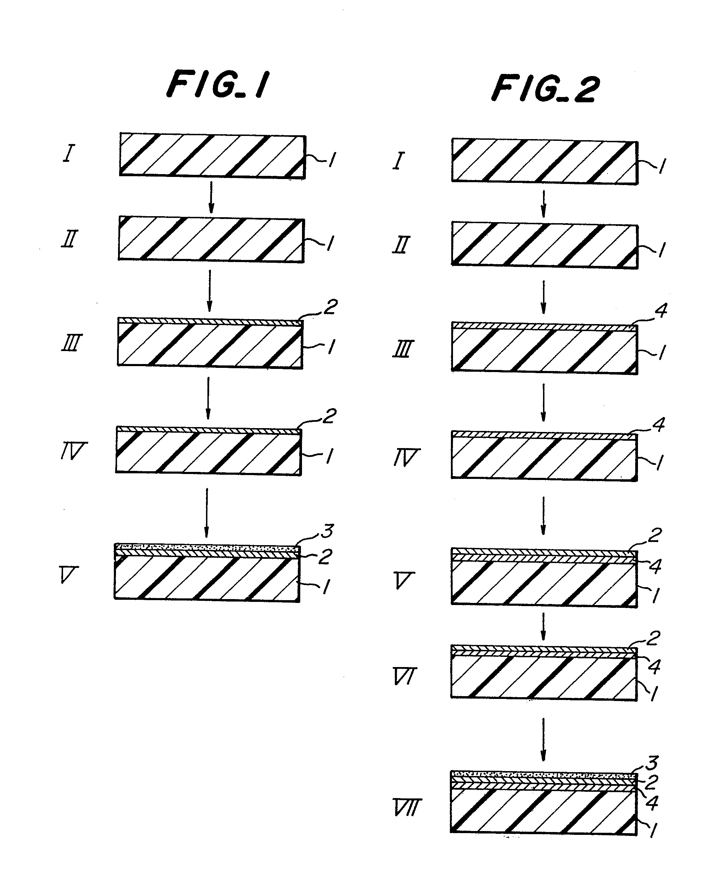

As shown in Fig. 1, step I of the method of the present invention comprises formation of plastic-molded article 1 by molding acrylic resin with injection or other appropriate molding process such as extrusion or casting. In step II, the molded article 1 is subjected to heat treatment or annealing, for the purpose of stress relaxation. This step may be unnecessary in case of vacuum-molded article or the like. In step III, the surface of the molded article is coated with "SUMIUNI", the above-mentioned silicone-based coating agent, by means of spray-, dipping- or flow-coating process, thereby to form a silicone-based coated layer 2 with a thickness of approximately $8 \pm 2$ μm which, in step IV, is subjected to baking at a temperature of 80°C for 1 hour or more. Subsequently, in step V, $SiO_2$ film 3 with a thickness of approximately $0.4 \sim 4$ μm is formed on the coated layer 2 by arc-discharge type ion plating process. More particularly, prior to the formation of $SiO_2$ film, the surface of the coated layer 2 is subjected to ion-bombardment cleaning at the pressure of $10^{-1} \sim 10^{-2}$ Torr for 10 minutes during the supply of argon gas and subsequently, after the supply of argon gas has been stopped, to a $SiO_2$ ion plating at the pressure of $10^{-5}$ Torr for 1 to 2 minutes. The article is then left cooled for 20 minutes while maintaining the vacuum, whereby a $SiO_2$ film is formed.

Example 2:

As shown in Fig. 2, a molded article 1 composed of polycarbonate resin is formed in step I, which is subjected to heat treatment in step II. Then, in step III, the surface of the article 1 is applied with a primer PH91 (trademark of Toshiba Silicone K.K.) which consists essentially of acrylic polymer, to form a primer layer 4 with a thickness of approximately $0.5 \sim 2.0$ μm which in step IV is subjected to a setting for 40 minutes at a temperature of 25°C. Subsequently, in step V, the abovementioned silicone-based coating agent, "TOSGUARD 510" is applied to form a silicone-based coated layer 2 with a thickness of approximately $8 \pm 2$ μm which, in step VI, is subjected to baking at a temperature of 120°C for 60-90 minutes. Furthermore, in step VII, a $SiO_2$ film with a thickness of approximately $0.4 \sim 4$ μm is formed in the manner described with reference to step V in the above-mentioned example 1.

Tests have been made with respect to various properties of the plastic-molded articles with hard coated surface layers, produced by the above-mentioned examples, and also to corresponding properties of comparative samples 1 and 2 without the $SiO_2$ film. The test results are as shown in the following table.

|  |  | Example 1 | | Sample 1 | Example 2 | | | | Sample 2 |
|---|---|---|---|---|---|---|---|---|---|
| Thickness of SiO$_2$ film (µm) | | 0.4 | 1.0 | 0 | 0.4 | 1.0 | 2.0 | 3.0 | 0 |
| Anti-crack property (unaided visual observation) | | ○ | ○ | ○ | ○ | ○ | ○ | ○ | ○ |
| Adhesion (cross-cut method)    1) | | ○ | ○ | ○ | ○ | ○ | ○ | ○ | ○ |
| Moisture resistance; 50°C, 98% RH, 240 Hrs. | | ○ | ○ | ○ | ○ | ○ | ○ | ○ | ○ |
| Traverse wear resistance | 5,000 times | ○ | ○ | ○ | ○ | ○ | ○ | ○ | ○ |
| | 40,000 times | ○ | ○ | ○ | ○ | ○ | ○ | ○ | ○ |
| Washing; top brush, 4,000 sec. | | ○ | ○ | ○ | ○ | ○ | ○ | ○ | ○ |
| Heat-cycle test (80°C×40 Hrs.→ -40°C×1.5 Hrs.; 2 cycles) | | ○ | ○ | ○ | ○ | ○ | ○ | ○ | ○ |
| Pencil hardness (under 100 G load) | | 7H | 7H | 5H | 6H | 6H | 6H | 6H | 4H |
| Scratch-proof against steel-wool (#000)    2) | | ○ | ○ | △ | ○ | ○ | ○ | ○ | △ |
| Transparency | | ○ | ○ | ○ | ○ | ○ | ○ | ○ | ○ |

Remarks:    1) ○ ··· 100/100
            2) ○ ··· good;    △ ··· slight scratches observed
            3) For other properties,    ○ indicates good.

The test results reveal that the plastic-molded articles without the SiO$_2$ film, i.e. comparative samples 1 and 2, are inferior in hardness and scratch proof properties, whereas the articles with the SiO$_2$ film, produced by

the present invention, provides excellent and satisfactory properties.

It will be appreciated that, in accordance with the present invention, the surface of plastic-molded articles is formed with a silicone-based coated layer which, in turn, is formed with a $SiO_2$ film. Consequently, it is possible to produce plastic-molded articles with hard coated surface layers firmly adhered to the base material, with capability of effectively preventing undesirable separation or crack-formation, while at the same time providing excellent hardness, scratch-proof and wear resistance properties.

## Claims

1. A method of producing plastic-molded articles with a hard coated surface layer, comprising the steps of forming a silicone-based coated layer on the surface of base material, and forming a $SiO_2$ film on said silicone-based coated layer.

2. The method as claimed in claim 1, in which said silicone-based coated layer is formed on a primer layer.

3. The method as claimed in claim 1 or 2, in which said $SiO_2$ film is formed in vacuum, by means of a physical vapor deposition process.

4. The method as claimed in claim 3, in which said physical vapor deposition process comprises an ion-plating process.

FIG_1

FIG_2

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 713 869 (W. GEFFCKEN et al.) * Claim 3; column 3, line 45 - column 4, line 18; examples * | 1,3 | C 08 J 7/04 C 23 C 14/02 |
| Y | | 1-4 | |
| Y | US-A-4 200 681 (W.L. HALL et al.) * Claims 1,5,6; examples * | 1-3 | |
| Y | CHEMICAL ABSTRACTS, vol. 94, no. 16, April 20, 1981, abstract no. 123257n, Columbus, Ohio, US; & JP-A-55 110 774 (SUWA SEIKOSHA CO., LTD) 26-08-1980 * Abstract * | 1-4 | |
| X | US-A-3 637 416 (R.D. MISCH et al.) * Claim 1; figure * | 1 | |
| A | US-A-3 707 397 (D.W. GAGNON) * Claims 1-7 * | | |

TECHNICAL FIELDS SEARCHED (Int. Cl.4)

C 08 J

The present search report has been drawn up for all claims

| Place of search | Date of completion of the search | Examiner |
|---|---|---|
| THE HAGUE | 12-01-1988 | HALLEMEESCH A.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P0401)